# EUROPÄISCHE PATENTSCHRIFT

(11) **EP 0 371 163 B1**
(45) Veröffentlichungstag und Bekanntmachung des Hinweises auf die Patenterteilung: **04.08.1993**
(21) Anmeldenummer: 88119914.5
(22) Anmeldetag: 29.11.1988
(51) Int. Cl.: H03K 5/13

(54) **Integrierbare Schaltungsanordnung zur Verzögerung impulsförmiger Signale**
Delay circuit for pulse signals, suitable for integration
Circuit de retard pour signaux impulsionnels, pouvant être intégré

(43) Veröffentlichungstag der Anmeldung: 06.06.1990
(73) Patentinhaber: SIEMENS AKTIENGESELLSCHAFT, 80333 München (DE)
(72) Erfinder: Donig, Günter, Dipl.-Ing. (FH), D-8012 Ottobrunn (DE)

(56) Entgegenhaltungen:
- IBM TECHNICAL DISCLOSURE BULLETIN, Band 30, Nr. 3, August 1987, Seiten 1183-1186, Armonk, New York, US; "Time delay circuit for pulse signal"
- IBM TECHNICAL DISCLOSURE BULLETIN, Band 16, Nr. 11, April 1974, Seiten 3498-3500, New York, US; P.T. MARINO: "Variable delay pulse circuits"

## Beschreibung

Die vorliegende Erfindung betrifft eine integrierbare Schaltungsanordnung zur Verzögerung impulsförmiger Signale nach dem Oberbegriff des Patentanspruches 1.

In der Impulstechnik ist es häufig notwendig Signale um eine gegebene Zeitspanne zu verzögern. Insbesondere die Verteilung von Taktsignalen in größeren, schnellen Digitalschaltungen erfordert den Ausgleich von Signallaufzeiten auf den verschieden langen Signalpfaden. Wie beispielsweise aus Emmo A. Zuiderveen, Handbuch der digitalen Schaltungen, 2. Auflage 1985, Seite 200 bekannt ist, wird der Laufzeitabgleich üblicherweise mit Leitungsnachbildungen durch passive Bauelemente oder durch Hintereinanderschalten mehrerer Gatter durchgeführt. Ein Leitungsabgleich mit einer der bekannten Schaltungsanordnungen gestaltet sich jedoch als schwierig, da eine Dimensionierung der passiven Bauelemente nur in einem sehr eingeschränkten Bereich möglich ist bzw. da bei Verwendung von Gattern nur ganzzahlige Vielfache der Verzögerungszeit eines Gatters erzeugt werden können.

Eine integrierte Schaltungsanordnung zur Verzögerung impulsförmiger Signale, bei der die Verzögerungszeit einstellbar ist, ist beispielsweise aus IBM Technical Disclosure Bulletin, Band 3, Aug. 1987, No. 3, Seiten 1183-1186 bekannt. Diese besteht aus einem Differenzverstärker mit einem durch eine Stromquelle gespeisten Transistorpaar, in dessen Lastkreis sich identische Widerstände befinden und deren Transistoren durch zueinander inverse Signale angesteuert werden. Zwischen die Kollektoren der beiden Transistoren, die über jeweils zwei antiparallel geschaltete Dioden an ein Hilfspotential angeschlossen sind, ist ein Kondensator geschaltet.

Nachteilig ist, daß der Differenzverstärker in Sättigung gesteuert wird, woraus eine lange Erholzeit resultiert.

Aufgabe der Erfindung ist es, eine Schaltungsanordnung der eingangs genannten Art anzugeben, die diesen Nachteil nicht aufweist.

Daie Aufgabe wird bei einer gattungsgemäßen Schaltungsanordnung durch die kennzeichnenden Merkmale des Patentanspruches 1 gelöst.

Weiterbildungen und Ausgestaltungen der Erfindung sind Gegenstand von Unteransprüchen.

Vorteil der Erfindung ist es, daß die Verzögerungszeit über einen weiten Bereich auf einfache Weise einstellbar ist. Weiterhin ist es vorteilhaft, daß sich am Ausgang gleiche Schaltflanken unabhängig von der eingestellten Verzögerungszeit ergeben. Darüber hinaus benötigt eine erfindungsgemäße Schaltungsanordnung abgesehen von der Mindestlaufzeit keine zusätzliche Erholzeit zwischen dem Wechsel des Ausgangssignals und dem Wechsel des Eingangssignals.

Die Erfindung wird nachfolgend anhand von den in den Figuren der Zeichnung dargestellten Ausführungsbeispielen näher erläutert. Es zeigt:
- FIG 1: ein erstes Ausführungsbeispiel einer erfindungsgemäßen Schaltungsanordnung,
- FIG 2: ein zweites Ausführungsbeispiel einer erfindungsgemäßen Schaltungsanordnung,
- FIG 3: ein drittes Ausführungsbeispiel einer erfindungsgemäßen Schaltungsanordnung,
- FIG 4: den Signalverlauf einer erfindungsgemäßen Schaltungsanordnung.

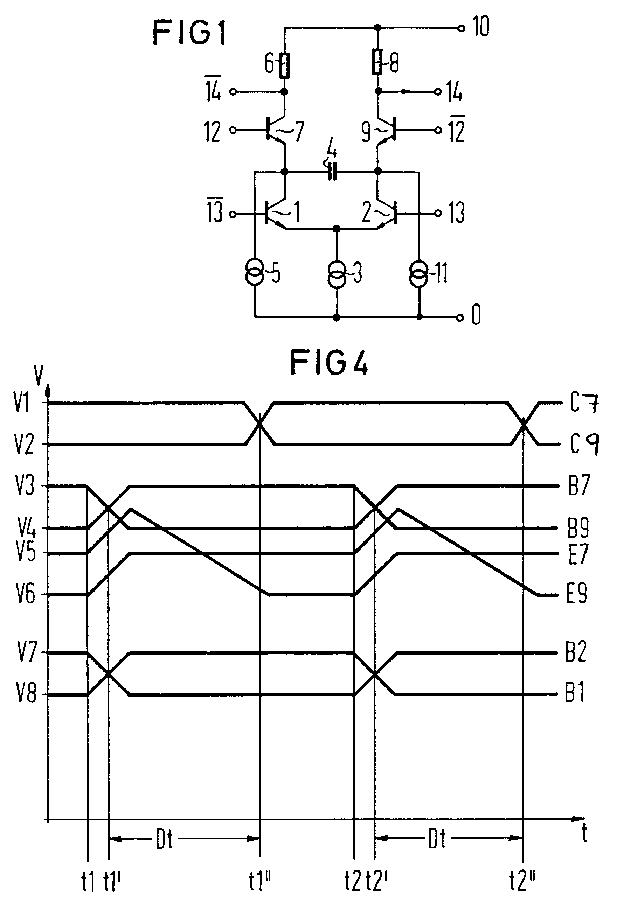

Das in FIG 1 der Zeichnung dargestellte Ausführungsbeispiel umfaßt ein in Differenzverstärkerschaltung betriebenes Transistorpaar, bestehend aus einem ersten Transistor 1 und einem zweiten Transistor 2, deren gekoppelte Emitter über eine erste Stromquelle 3 auf Nullpotential 0 liegen und deren Kollektoren über einen Kondensator 4 miteinander verbunden sind. Der Kollektor des ersten Transistors 1 ist darüber hinaus zum einen über eine zweite Stromquelle 5 an dem Nullpotential 0 und zum anderen an dem Emitter eines kollektorseitig über einen ersten Widerstand 6 mit einem ersten Versorgungspotential 10 verbundenen dritten Transistor 7 angeschlossen. In gleicher Weise ist der Kollektor des zweiten Transistors 2 zum einen über eine dritte Stromquelle 11 an dem Nullpotential 0 und zum anderen an dem Emitter eines kollektorseitig über einen zweiten Widerstand 8 mit dem ersten Versorgungspotential 10 verbundenen vierten Transistor 9 angeschlossen. Die Basis des dritten Transistors 7 ist als erster nichtinvertierender Eingang 12 und die Basis des vierten Transistors 9 ist als erster invertierender Eingang 1̅2̅ vorgesehen. Darüber hinaus umfaßt die gezeigte Schaltungsanordnung einen zweiten invertierenden Eingang 1̅3̅, der durch die Basis des ersten Transistors 1 gebildet wird. Ein invertierter Ausgang 1̅4̅ ist an dem Kollektor des dritten Transistors 7 und ein nicht invertierter Ausgang 14 ist an dem Kollektor des vierten Transistors 9 angeschlossen. Die zwischen den beiden invertierenden Eingängen 1̅2̅, 1̅3̅ und zwischen den beiden nichtinvertierenden Eingängen 12, 13 anliegenden Potentialdifferenzen sind dabei derart bemessen, daß eine Sättigung des ersten und zweiten Transistors 1, 2 vermieden wird.

In Ausgestaltung der Erfindung sind der erste und zweite Transistor 1, 2, der dritte und vierte Transistor 7, 9, sowie die zweite und dritte Stromquelle 5, 11 sowie der erste und zweite Widerstand 6, 8 jeweils identisch aufgebaut. Die Vorteile dieses symmetrischen Aufbaus liegen darin, daß sich zum einen damit für positive und negative Flanken des Eingangssignales gleiche Laufzeiten ergeben und daß zum anderen dadurch der Einfluß von Fertigungstoleranzen bei der Integration der Schaltungsanordnung verringert wird.

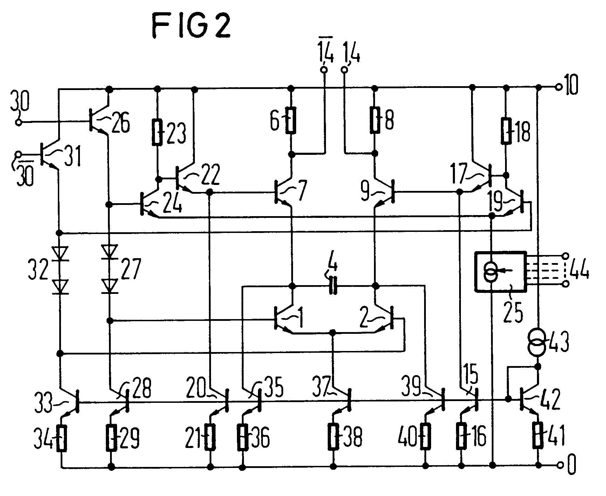

FIG 2 zeigt eine Weiterbildung einer erfindungsgemäßen Schaltungsanordnung, welche ausgehend von dem Ausführungsbeispiel aus FIG 1 um eine Ansteuerstufe erweitert ist. Dabei sind, wie allgemein in der Zeichnung, gleiche Elemente mit gleichen Bezugszeichen versehen. Die den ersten invertierenden Eingang 1̅2̅ der Anordnung nach FIG 1 bildende Basis des dritten Transistors 7 ist dazu zum einen über eine vierte Stromquelle 20, 21, 41, 42, 43 mit dem Nullpotential 0 und zum anderen mit dem Emitter eines fünften Transistors 22, der kollektorseitig an dem ersten Versorgungspotential 10 und basisseitig an dem über einen dritten Widerstand 23 mit dem ersten Versorgungspotential 10 verbundenen Kollektor eines siebten Transistors 24 liegt, verschaltet. Ebenso ist die den ersten nichtinvertierenden Eingang 12 der Anordnung nach FIG 1 bildende Basis des vierten Transistors 9 zum einen über eine fünfte Stromquelle 15, 16, 41, 42, 43 mit dem Nullpotential 0 und zum anderen mit dem Emitter eines sechsten Transistors 17, der kollektorseitig an dem ersten Versorgungspotential 10 und basisseitig an dem über einen vierten Widerstand 18 mit dem ersten Versorgungspotential 10 verbundenen Kollektor eines achten Transistors 19 liegt, verschaltet. Die gekoppelten Emitter des siebten und achten Transistors 24, 19 sind über eine sechste Stromquelle 25 mit dem Nullpotential 0 verbunden. Ein kollektorseitig auf erstem Versorgungspotential 10 liegender neunter Transistor 26, dessen Basis als invertierender Eingang 30 vorgesehen ist, ist emitterseitig mit der Basis des siebten Transistors 24 und einem Anschluß eines ersten seriellen Diodenpaares 27 in Durchlaßrichtung, dessen zweiter Anschluß zum einen mit der Basis des ersten Transistors 1 verbunden ist und zum anderen über eine siebte Stromquelle 28, 29, 41, 42, 43 an dem Nullpotential 0 liegt, verschaltet. In gleicher Weise ist ein kollektorseitig an dem ersten Versorgungspotential 10 liegender zehnter Transistor 31, dessen Basis als nichtinvertierender Eingang 3̅0̅ vorgesehen ist, emitterseitig mit der Basis des achten Transistors 19 und einem Anschluß eines zweiten seriellen Diodenpaares 32 in Durchlaßrichtung, dessen zweiter Anschluß zum einen mit der Basis des zweiten Transistors 2 verschaltet ist und zum anderen über eine achte Stromquelle 33, 34, 41, 42, 43 an dem Nullpotential 0 liegt, verbunden.

In Ausgestaltung der Erfindung sind der fünfte und sechste Transistor 22, 17, der siebte und achte Transistor 24, 19, der neunte und zehnte Transistor 26, 31, die vierte und fünfte Stromquelle 20, 21, 15, 16, 41, 42, 43, die siebte und achte Stromquelle 28, 29, 33, 34, 41, 42, 43, das erste und zweite Diodenpaar 27, 32, sowie der dritte und vierte Widerstand 23, 18 jeweils identisch aufgebaut. Die Vorteile dieses symmetrischen Aufbaus liegen darin, daß sich zum einen damit für positive und negative Flanken des Eingangssignales gleiche Laufzeiten ergeben und daß zum anderen dadurch der Einfluß von Fertigungstoleranzen bei der Integration der Schaltungsanordnung verringert wird.

Als erste, zweite, dritte, vierte, fünfte, siebte und achte Stromquelle sind die Erfindung ausgestaltend jeweils die Ausgangsstufen eines siebenstufigen Stromspiegels, bestehend aus einem elften, zwölften, dreizehnten, vierzehnten, fünfzehnten, sechzehn und siebzehnten Transistor 33, 28, 20, 35, 37, 39, 15 und aus einem fünften, sechsten, siebten, achten, neunten, zehnten und elften Widerstand 34, 29, 21, 36, 38, 40, 16 als Ausgangsstufen sowie aus einem zu einer Diode verschalteten achtzehnten Transistor 42 und einem zwölften Widerstand 41 als Eingangsstufe vorgesehen. Eingangsseitig ist der Stromspiegel mit einer neunten Stromquelle 43 beaufschlagt. Der Vorteil liegt darin, daß ein geringer schaltungstechnischer Aufwand bei der Ausführung der Stromquellen nötig ist.

In Weiterbildung der Erfindung ist als sechste Stromquelle 25 ein Digitalanalogwandler mit Stromausgang vorgesehen, der über seine Datenleitungen 44 digital ansteuerbar ist. Das bringt den Vorteil mit sich, daß die Einstellung der Verzögerungszeit von einer digitalen Recheneinheit vorgenommen werden kann.

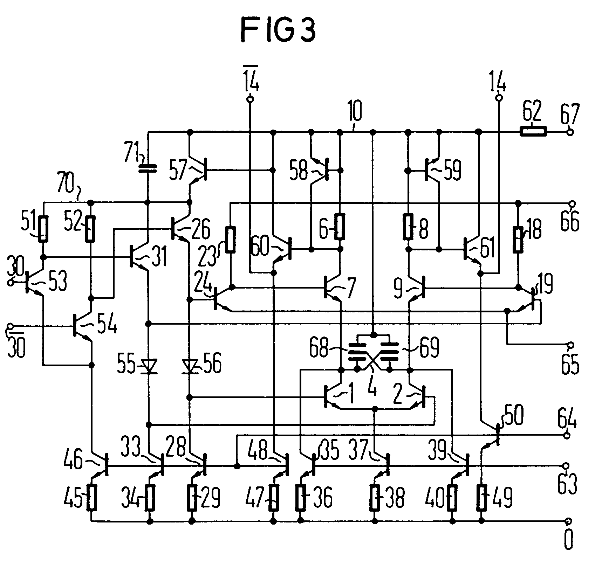

Das Ausführungsbeispiel gemäß FIG 3 zeigt die Schaltungsanordnung nach FIG 2 dahingehend weitergebildet, daß der zwischen die Kollektoren von erstem und zweitem Transistor 1, 2 geschaltete Kondensator 4 in zwei Teilkondensatoren 68, 69 mit je drei hintereinander geschalteten Platten aufgeteilt ist. Jeweils eine äußere Platte der Teilkondensatoren 68, 69 ist mit einem Hilfspotential beaufschlagt, das im vorliegenden Ausführungsbeispiel gleich dem ersten Versorgungspotential 10 ist. Die andere äußere Platte jeweils eines Teilkondensators ist mit der mittleren Platte des jeweils anderen Teilkondensators verbunden. Die so über Kreuz miteinander verschalteten Platten sind an dem Kollektor des ersten Transistors 1 bzw. an den Kollektor des zweiten Transistors 2 angeschlossen. Eine derartige Aufteilung des Kondensators 4 ist insbesondere bei dessen Realisierung in integrierter Schaltungstechnik zweckmäßig, um den Einfluß von mit dem Substrat gebildeten, parasitären Kapazitäten zu kompensieren. Bei einem Potentialsprung an dem Emitter des dritten Transistors 7 oder an dem Emitter des vierten Transistors 9 nämlich wird der Umladestrom des Parasitäranteils der Teilkondensatoren 68, 69 von dem Emitter des schaltenden Transistors über die an dem Hilfspotential liegenden Platten an den Kollektor des dritten Transistors 7 bzw. an den Kollektor des vierten Transistors 9 zurückgeführt. Ein identischer Aufbau der beiden Teilkapazitäten 68, 69 ist zweckmäßig, um gleiche elektrische Eigenschaften zu gewährleisten.

Des weiteren ist dem ersten und zweiten Widerstand 6, 8 in Ausgestaltung der Erfindung jeweils eine Klemmdiode in Durchlaßrichtung parallel geschaltet. Das bringt den Vorteil mit sich, daß an den Kollektoren von drittem und viertem Transistor 7, 9 auftretende Potentiale jeweils auf den Betrag des Versorgungspotentials 10 abzüglich der Diodendurchlaßspannung begrenzt werden. Im gezeigten Ausführungsbeispiel sind als Klemmdioden zwei zu Dioden verschaltete, invers betriebene Transistoren 58, 59 vorgesehen.

Darüber hinaus ist auch gegenüber FIG 2 die dort ausgeführte Ansteuerstufe in FIG 3 abgeändert. Die Basis des dritten Transistors 7 ist in Weiterbildung der Erfindung direkt an den Kollektor des siebten Transistors 24 angeschlossen. Ebenso ist auch die Basis des vierten Transistors 9 mit dem Kollektor des achten Transistors 19 direkt verbunden. Der Kollektor des siebten Transistors 24 liegt über den dritten Widerstand 23 und der Kollektor des achten Transistors 19 über den vierten Widerstand 18 nun an einem zweiten Versorgungspotential 66. Die Kollektoren des neunten und zehnten Transistors 26, 31, deren Emitter nun lediglich jeweils über eine erste bzw. zweite Diode 55, 56 in Durchlaßrichtung auf die achte Stromquelle 33, 34 bzw. auf die siebte Stromquelle 28, 29 geführt sind, sind mit einem dritten Versorgungspotential 70 beaufschlagt. An dem dritten Versorgungspotential 70 liegt auch ein Differenzverstärker, dessen Eingänge als nichtinvertierender Eingang 3̅0̅ und als invertierender Eingang 30 der Schaltungsanordnung vorgesehen sind und dessen Ausgänge mit der Basis des zehnten Transistors 31 bzw. dem neunten Transistor 26 verbunden sind. Der Differenzverstärker weist zwei emittergekoppelte Transistoren 53, 54 welche emitterseitig über eine zehnte Stromquelle 45, 46, 64 an dem Nullpotential 0 liegen, und zwei Kollektorwiderstände 51, 52 auf. Durch den Verzicht auf fünften und sechsten Transistor 22, 17, sowie durch Ersatz der beiden Diodenpaare 33, 27 durch eine erste und zweite Diode 55, 56 ergibt sich der Vorteil, daß das dritte Versorgungspotential 70 um den Betrag der Durchlaßspannung einer Diode geringer angesetzt werden kann.

Dabei geht das dritte Versorgungspotential 70 aus dem ersten Versorgungspotential 10 dadurch hervor, daß beide Potentiale über eine Parallelschaltung eines weiteren Kondensators 71 und eines als weitere Diode geschalteten Transistors 57 in Durchlaßrichtung miteinander verbunden sind. Das erste Versorgungspotential 10 wiederum ist über einen Vorwiderstand 62 an ein viertes Versorgungspotential 67 gelegt. Dies bringt den Vorteil mit sich, daß zur Versorgung der Schaltungsanordnung nur ein Hauptversorgungspotential, nämlich das vierte Versorgungspotential 67, benötigt wird, da die anderen Versorgungspotentiale daraus intern erzeugt werden.

Die Erfindung ausgestaltend sind bei der Ansteuerschaltung gemäß FIG 3 der siebte und achte Transistor 24, 19, der neunte und zehnte Transistor 26, 31, der elfte und zwölfte Transistor 54, 53, die siebte und achte Stromeinprägung 28, 29, 33, 34, die erste und zweite Diode 55, 56, sowie der dritte und vierte Widerstand 23, 18 jeweils identisch ausgeführt. Darüber hinaus ist auch der Differenzverstärker 45, 46, 51, 52, 53, 54 symmetrisch aufgebaut.

Weiterhin sind als erste, zweite und dritte Stromquelle die Ausgangsstufen 35, 36, 37, 38, 39, 40 eines dreistufigen zweiten Stromspiegels mit einer ein erstes Referenzpotential 63 erzeugenden, in der Zeichnung nicht näher ausgeführten, ersten Referenzspannungsquelle als Eingangsstufe und als siebte, achte, zehnte Stromquelle die Ausgangsstufen 28, 29, 33, 34, 45, 46 eines dreistufigen dritten Stromspiegels mit einer ein zweites Referenzpotential 64 erzeugenden, in der Zeichnung nicht näher ausgeführten, zweiten Referenzspannungsquelle als Eingangsstufe vorgesehen. Schließlich sind die erste, zweite und dritte Stromquelle so ausgelegt, daß die Stromdichte in dem vierzehnten, fünfzehnten, sechzehnten Transistor 35, 37, 39 gleich groß ist. Der Vorteil des vorstehend aufgezeigten symmetrischen Aufbaus sowie der gleichen Stromdichte in den Transistoren der Ausgangsstufen des zweiten Stromspiegels besteht darin, daß sich beispielsweise temperaturbedingte Schwankungen der Arbeitspunkte kompensieren.

Die an dem invertierenden und nichtinvertierenden Ausgang 1̅4̅, 14 anliegenden Signale sind in dem Ausführungsbeispiel gemäß FIG 3 die Erfindung ausgestaltend jeweils über einen Emitterfolger geführt. Die beiden Emitterfolger werden durch jeweils einen zweiundzwanzigsten und dreiundzwanzigsten Transistor 60, 61 gebildet, welche jeweils emitterseitig mit einer weiteren Stromquelle beaufschlagt sind. Die weiteren Stromquellen sind zwei weitere Ausgangszweige des dritten Stromspiegels mit jeweils einem Transistor 58, 50 und einem Emitterwiderstand 47, 49. Die Beschaltung der Ausgänge 1̅4̅, 14 mit Emitterfolgern ist vorteilhaft, um mit geringem aufwand Rückwirkungen von den Ausgängen 1̅4̅, 14 her auf die Schaltungsanordnung zu verhindern und gleichzeitig den Ausgangsstrom zu erhöhen. In gleichem Maße sind jedoch auch Verstärkerschaltungen zur Pufferung der Ausgänge 1̅4̅, 14 geeignet.

In FIG 3 der Zeichnung ist die in FIG 2 gezeigte sechste Stromquelle 25 nicht näher ausgeführt. Statt dessen ist ein mit den gekoppelten Emittern des siebten und achten Transistors 24, 19 verbundene Anschluß 65 für eine externe Stromquelle vorgesehen.

Bei den in den Ausführungsbeispielen dargestellten Transistoren handelt es sich ausschließlich um npn-Typen. Es ist jedoch auch entsprechend die Verwendung von pnp-Typen in gleicher Weise möglich. Darüber hinaus besteht die Möglichkeit eine erfindungsgemäße Schaltungsanordnung auch ganz oder teilweise in MOS- Technologie zu realisieren.

Nachdem zuvor der prinzipielle Aufbau der in den Figuren der Zeichnung dargestellten Schaltungsanordnungen erläutert worden ist, sei nunmehr auf deren Arbeitsweise näher eingegangen.

In FIG 4 der Zeichnung ist der Signalverlauf bei einer erfindungsgemäßen Schaltungsanordnung in einem Diagramm als Potential V über der Zeit t aufgetragen. An der Basis des dritten Transistors 7 liegt ein zu verzögerndes Signal B7 und an der Basis des vierten Transistors 9 liegt das entsprechende, jedoch invertierte Signal B9 an. Dabei führt das zu verzögernde Signal B7 zunächst ein Potential V3, um dann zu einem gegebenen ersten Zeitpunkt t1 auf ein niedrigeres Potential V4 zu kippen und zu einem gegebenen zweiten Zeitpunkt t2 wieder zurück auf das Potential V3 zu springen. Invers dazu ändern sich die Potentiale an der Basis des vierten Transistors 9 zwischen dem Potential V4 und dem Potential V3. Ein Zeitpunkt t1' und ein Zeitpunkt t2' charakterisieren dabei jeweils den Zeitpunkt des Signalüberganges. In gleicher Weise wie die Signale B7 und B9 verhalten sich auch das Signal B2 an der Basis des zweiten Transistors 2 und das Signal B1 an der Basis des Transistors 1, wobei dem Potential V3 entsprechend ein Potential V7 und dem Potential V4 entsprechend ein Potential V8 auftritt. Die Potentiale V7 und V8 liegen jedoch soweit unter den Potentialen V3 und V4, daß eine Sättigung des dritten und vierten Transistors 7, 9 vermieden wird.

Das am Emitter des vierten Transistors 9 auftretende Signal E9 führt bis zum Zeitpunkt t1 ein Potential V6, um dann anzusteigen bis zum Erreichen eines Potentiales V5, welches daraufhin bis zum Zeitpunkt t2' beibehalten wird. Das am Emitter des dritten Transistors 7 auftretende Signal E7 hält bis zum Zeitpunkt t1' das Potential V5, steigt bis zum Erreichen des Doppelten der Differenz der Potentiale V5 und V6 an und fällt dann bis zum Erreichen des Potentiales V6. Der Transistor 1 befindet sich zum Zeitpunkt t1 und der Transistor 2 zum Zeitpunkt t2 in völlig ausgeschaltetem Zustand. Zum Zeitpunkt t1'' wird der Schwellwert des vierten Transistors 9 erreicht und dieser durchgesteuert. Daraufhin ändert sich zu einem Zeitpunkt t1'' das Signal C9 am Kollektor des vierten Transistors 9 von einem Potential V1 zu einem Potential V2. Umgekehrt dazu erfolgt die Änderung des am Kollektor des dritten Transistors 7 auftretenden Signales C7 von dem Potential V2 zum Potential V1. Vom Zeitpunkt t₂ bis zu einem Zeitpunkt t₂'' verhält sich das Signal E9 in gleicher Weise wie das Signal E7 zwischen dem Zeitpunkt t₁ und dem Zeitpunkt t₁''. Beim Anheben des Potentiales am Emitter des dritten Transistors 7 wird der Emitter des vierten Transistors 9 mitangehoben, da sich die Spannung U am Kondensator 4 zunächst nicht ändert. Die Basis des vierten Transistors 9 wird dabei um den selben Betrag abgesenkt mit dem die Basis des dritten Transistors 7 angehoben wird. Somit ergibt sich über dem Kondensator 4 die doppelte Umschaltspannung, die durch einen doppelten Ladestrom I ausgeglichen werden muß. Die Zeit zwischen t1' und t1'' ergibt die Verzögerungszeit Dt. Zum Zeitpunkt t2 gehen die ver Zögerten Signale B1, B2, B7, B9 wieder in ihren ursprünglichen Zustand zurück. Dadurch wird zu den Zeiten t2, t2', t2'' der umgekehrte Signalverlauf wie zu den Zeitpunkten t1, t1', t1'' ausgelöst, wobei die Verzögerungszeit Dt durch die Differenz von t2' und t2'' gebildet wird. Für die anliegenden Potentiale ergibt sich die Bedingung V1 > V2 > V3 > V4 > V5 > V6 > V7 > V8.

Formal läßt sich die Abhängigkeit der Verzögerungszeit Dt von der Kapazität C des Kondensators 4 sowie von der Spannung U über den Kondensator 4 im eingeschwungenen Zustand und von dem Ladestrom I des Kondensators 4 durch die Gleichung Dt = C (2 U/I) beschreiben. Durch Ändern des Ladedtromes I - dies geschieht beispielsweise durch Verändern des Stromes der ersten Stromeinprägung 3 - kann die Verzögerungszeit Dt in einem bestimmten Bereich beeinflußt werden. Wird, wie in FIG 2 und FIG 3 der Zeichnung dargestellt, die Schaltungsanordnung in Weiterbildung der Erfindung mit einer zusätzlichen Ansteuerschaltung beaufschlagt, so kann die Spannung U am Kondensator 4 und damit auch die Verzägerungszeit Dt in linearer Abhängigkeit von dem durch die sechste Stromquelle 25 festgelegten Strom eingestellt werden. Der Vorteil liegt darin, daß zwischen Einstellgröße und Verzögerungszeit ein linearer Zusammenhang besteht, was insbesondere bei der Verwendung eines Digitalanalogwandlers zur Stromquelle von Bedeutung ist. Für den Fall daß der Strom der sechsten Stromquelle 25 gleich Null ist, ergibt sich die Grundlaufzeit, die unter anderem auch von dem Strom der ersten Stromquelle 3 abhängig ist.

## Patentansprüche

1. Integrierbare Schaltungsanordnung zur Verzögerung impulsförmiger Signale,
mit einem durch ein Eingangssignal kippbaren Differenzverstärker mit einem ersten und zweiten Transistor (1, 2), deren gekoppelte Emitter über eine Stromquelle (3; 37, 38) an einem Nullpotential (0) liegen und deren Kollektoren durch einen Kondensator (4) miteinander verbunden sind und deren Basen synchron zu dem Eingangssignal und zueinander invers angesteuert werden,
**dadurch gekennzeichnet,** daß der Kollektor des ersten Transistors (1) zum einen über eine zweite Stromquelle (5; 35, 36) an dem Nullpotential (0) und zum anderen an dem Emitter eines kollektorseitig über einem ersten Widerstand (6) mit einem ersten Versorgungspotential (10) verbundenen dritten Transistors (7) angeschlossen ist, daß der Kollektor des zweiten Transistors (2) zum einen über eine dritte Stromquelle (11; 39, 40) an dem Nullpotential (0) und zum anderen an dem Emitter eines kollektorseitig über einen zweiten Widerstand (8) mit dem ersten Versorgungspotential (10) verbundenen vierten Transistors (9) angeschlossen ist, daß der Kollektor des dritten Transistors (7) als invertierter Ausgang (1̅4̅) und der Kollektor des vierten Transistors (9) als nichtinvertierter Ausgang (14) vorgesehen ist, daß erster und vierter Transistor (1, 9) bzw. zweiter und dritter Transistor (2, 7) synchron zueinander angesteuert werden und daß die bei der Ansteuerung der Basen von drittem und viertem Transistor (7, 9) auftretenden Potentiale derart höher als die bei der Ansteuerung der Basen von erstem und zweitem Transistor (1, 2) gewählt sind, daß eine Sättigung von erstem und zweitem Transistor (1, 2) vermieden wird.

2. Integrierbare Schaltungsanordnung nach Anspruch 1,
**dadurch gekennzeichnet,** daß der Kondensator (4) in zwei identische Teilkondensatoren (68, 69) mit je drei hintereinanderliegenden Platten aufgeteilt ist, daß jeweils eine äußere Platte der Teilkondensatoren mit einem Hilfspotential (67) beaufschlagt ist und daß die beiden anderen Platten des einen Teilkondensators mit den beiden anderen Platten des anderen Teilkondensators die Anschlüsse des Kondensators (4) bildend über Kreuz verbunden sind.

3. Integrierbare Schaltungsanordnung nach Anspruch 2,
**dadurch gekennzeichnet,** daß dem ersten und zweiten Widerstand (6, 8) jeweils eine Klemmdiode (58, 59) in Durchlaßrichtung parallel geschaltet ist.

4. Integrierbare Schaltungsanordnung nach einem der Ansprüche 1 bis 3,
**dadurch gekennzeichnet**, daß der erste und zweite Transistor (1, 2), der dritte und vierte Transistor (7, 9), die zweite und dritte Stromeinquelle (5; 35, 36; 11; 39, 40) sowie der erste und zweite Widerstand (6, 8) jeweils identisch aufgebaut sind.

5. Integrierbare Schaltungsanordnung nach einem der Ansprüche 1 bis 4,
**dadurch gekennzeichnet,** daß die Basis des dritten Transistors (7) zum einen über eine vierte Stromeinquelle (20, 21) an dem Nullpotential (0) liegt und zum anderen mit dem Emitter eines fünften Transistors (22), der kollektorseitig an dem ersten Versorgungspotential (10) und basisseitig an dem über einen dritten Widerstand (23) mit dem ersten Versorgungspotential (10) verbundenen Kollektor eines siebten Transistors (24) angeschlossen ist, verschaltet ist,
daß die Basis des vierten Transistors (9) zum einen über eine fünfte Stromeinquelle (15, 16) an dem Nullpotential (0) liegt und zum anderen mit dem Emitter eines sechsten Transistors (17), der kollektorseitig an dem ersten Versorgungspotential (10) und basisseitig an dem über einen vierten Widerstand (18) mit dem ersten Versorgungspotential (10) verbundenen Kollektor eines achten Transistors (19) angeschlossen ist, verschaltet ist,
daß die gekoppelten Emitter des siebten und achten Transistors (24, 19) über eine sechste Stromeinquelle (25) mit dem Nullpotential (0) verbunden sind,
daß ein kollektorseitig auf dem ersten Versorgungspotential (10) liegender neunter Transistor (26), dessen Basis als invertierender Eingang (30) vorgesehen ist, emitterseitig mit der Basis des siebten Transistors (24) und einem Anschluß eines ersten seriellen Diodenpaares (27) in Durchlaß richtung, dessen zweiter Anschluß zum einen mit der Basis des ersten Transistors (1) verbunden ist und zum anderen über eine siebte Stromquelle (28, 29) an dem Nullpotential (0) liegt, verschaltet ist und
daß ein kollektorseitig an dem ersten Versorgungspotential (10) liegender zehnter Transistor (31), dessen Basis als nichtinvertierender Eingang (3̅0̅) vorgesehen ist,
emitterseitig mit der Basis des achten Transistors (19) und einem Anschluß eines zweiten seriellen Diodenpaares (32) in Durchlaßrichtung, dessen zweiter Anschluß zum einen mit der Basis des zweiten Transistors (2) verbunden ist und zum anderen über eine achte Stromquelle (33, 34) an dem Nullpotential (0) liegt, verschaltet ist.

6. Integrierbare Schaltungsanordnung nach Anspruch 5,
**dadurch gekennzeichnet**, daß der fünfte und sechste Transistor (22, 17), der siebte und achte Transistor (24, 19) der neunte und zehnte Transistor (26, 31), die vierte und fünfte Stromquelle (20, 21; 15, 16), die siebte und achte Stromquelle (28, 29; 33, 34), sowie das erste und zweite Diodenpaar (27, 32) jeweils identisch ausgeführt sind und daß der dritte und vierte Widerstand (23, 18) den gleichen Widerstandswert aufweisen.

7. Integrierbare Schaltungsanordnung nach Anspruch 5 oder 6,
**dadurch gekennzeichnet**, daß als erste, zweite, dritte, vierte, fünfte, siebte und achte Stromquelle die Ausgangsstufen (37, 38; 35, 36; 39, 40; 20, 21; 15, 16; 28, 29; 33, 34) eines siebenstufigen ersten Stromspiegels, welcher eingangsseitig mit einer neunten Stromquelle (43) beaufschlagt ist, vorgesehen ist und daß der durch die sechste Stromquelle (25) gegebene Strom von außen einstellbar ist.

8. Integrierbare Schaltungsanordnung nach einem der Ansprüche 1 bis 4,
**dadurch gekennzeichnet,** daß die Basis des dritten Transistors (7) an den Kollektor eines siebten Transistors (24) und die Basis des vierten Transistors (9) an den Kollektor eines achten Transistors (19) angeschlossen ist,
daß der Kollektor des siebten Transistors (24) über einen dritten Widerstand (23) und der Kollektor des achten Transistors (19) über einen vierten Widerstand (18) an einem zweiten Versorgungspotential (66) liegt,
daß bei neuntem und zehntem Transistor (26, 31) die Kollektoren mit einem dritten Versorgungspotential (70) beaufschlagt und die Emitter über eine erste bzw. zweite Diode (56, 55) in Durchlaßrichtung und über eine siebte bzw. achte Stromquelle (28, 29; 33, 34) mit dem Nullpunkt (0) gekoppelt sind,
daß die Basis des neunten Transistors (26) und die Basis des zehnten Transistors (31) jeweils mit den Ausgängen eines Differenzverstärkers (45, 46, 51, 52, 53, 54) mit einer neunten Stromquelle (45, 46) verbunden ist und daß die Eingänge des Differenzverstärkers (45, 46, 51, 52, 53, 54) als invertierender und nichtinvertierender Eingang (30, 3̅0̅) vorgesehen sind.

9. Integrierbare Schaltungsanordnung nach Anspruch 8,
**dadurch gekennzeichnet,** daß als drittes Versorgungspotential das über einen weiteren Kondensator (71) und eine weitere Diode (57) in Durchlaßrichtung geführte erste Versorgungspotential (10) und als erstes Versorgungspotential (10) ein über einen Vorwiderstand (62) geführtes viertes Versorgungspotential (67) vorgesehen sind.

10. Integrierbare Schaltungsanordnung nach Anspruch 8 oder 9,
**dadurch gekennzeichnet,** daß der siebte und achte Transistor (24, 19), der neunte und zehnte Transistor (26, 31), die siebte und achte Stromquelle (28, 29; 33, 34), die erste und zweite Diode (55, 56), sowie der dritte und vierte Widerstand (23, 18) jeweils identisch ausgeführt sind.

11. Integrierbare Schaltungsanordnung nach Anspruch 8, 9 oder 10,
**dadurch gekennzeichnet,** daß erste, zweite und dritte Stromquelle als Ausgangsstufen (37, 38; 35, 36; 39, 40) eines dreistufigen zweiten Stromspiegels mit einer ein erstes Referenzpotential (63) erzeugenden Referenzspannungsquelle als Eingangsstufe und als siebte, achte und neunte Stromquelle die Ausgangsstufen (28, 29; 33, 34; 45, 46) eines dreistufigen dritten Stromspiegels mit einer ein zweites Referenzpotential (64) erzeugenden zweiten Referenzspannungsquelle als Eingangsstufe vorgesehen sind.

12. Integrierbare Schaltungsanordnung nach Anspruch 7 oder 11, **dadurch gekennzeichnet,** daß erste, zweite und dritte Stromquelle (37, 38; 35, 36; 39, 40) so ausgelegt sind, daß die Stromdichten in den Transistoren der jeweiligen Ausgangsstufen gleich groß sind.

13. Integrierbare Schaltungsanordnung nach einem der Ansprüche 5 bis 11,
**dadurch gekennzeichnet,** daß als sechste Stromquelle (25) ein Digitalanalogwandler mit Stromausgang vorgesehen ist.

14. Schaltungsanordnung nach einem der Ansprüche 1 bis 13, **dadurch gekennzeichnet,**
daß die am invertierten und nichtinvertierten Ausgang (1̅4̅, 14) liegenden Signale jeweils über Emitterfolger (47, 48, 60; 49, 50, 61) oder Verstärker geführt sind.

## Claims

1. Integrable circuit arrangement for delaying pulse-shaped signals, comprising a differential amplifier, which can be switched by an input signal, having a first and second transistor (1, 2), the coupled emitters of which are connected by a current source (3; 37, 38) to a zero potential (0) and the collectors of which are connected to one another by a capacitor (4) and the bases of which are driven synchronously with the input signal and inversely with respect to one another, characterised in that the collector of the first transistor (1) is connected, on the one hand, via a second current source (5; 35, 36) to the zero potential (0) and, on the other hand, to the emitter of a third transistor (7) which is connected at the collector end to a first supply potential (10) via a first resistor (6), in that the collector of the second transistor (2) is connected, on the one hand, via a third current source (11; 39, 40) to the zero potential (0) and, on the other hand, to the emitter of a fourth transistor (9) which is connected at the collector end to the first supply potential (10) via a second resistor (8), in that the collector of the third transistor (7) is provided as inverted output (1̅4̅) and the collector of the fourth transistor (9) is provided as non-inverted output (14), and in that the first and fourth transistor (1, 9) and second and third transistor (2, 7) are driven synchronously with respect to one another and in that the potentials occurring during the driving of the bases of the third and fourth transistor (7, 9) have been selected to be higher than those during the driving of the bases of the first and second transistor (1, 2) in such a manner that a saturation of the first and second transistor (1, 2) is avoided.

2. Integrable circuit arrangement according to Claim 1, characterised in that the capacitor (4) is divided into two identical part-capacitors (68, 69) having three series-connected plates each, in that in each case an auxiliary potential (67) is applied to one outer plate of the part-capacitors and in that the two other plates of one part-capacitor are cross-connected to the other two plates of the other part-capacitor, forming the terminals of the capacitor (4).

3. Integrable circuit arrangement according to Claim 2, characterised in that in each case one clamping diode (58, 59) is connected in the forward direction in parallel with the first and second resistor (6, 8).

4. Integrable circuit arrangement according to one of Claims 1 to 3, characterised in that the first and second transistor (1, 2), the third and fourth transistor (7, 9), the second and third current source (5; 35, 36; 11; 39) and the first and second resistor (6, 8) are in each case of identical construction.

5. Integrable circuit arrangement according to one of Claims 1 to 4, characterised in that the base of the third transistor (7) is connected, on the one hand, to the zero potential (0) via a fourth current source (20, 21) and, on the other hand, is connected to the emitter of a fifth transistor (22) which is connected at its collector end to the first supply potential (10) and at the base end to the collector of a seventh transistor (24), connected to the first supply potential (10) via a third resistor (23), in that the base of the fourth transistor (9) is connected, on the one hand, to the zero potential (0) via a fifth current source (15, 16) and, on the other hand, to the emitter of a sixth transistor (17) which is connected at the collector end to the first supply potential (10) and at the base end to the collector of an eighth transistor (19) which is connected to the first supply potential via a fourth resistor (18), in that the coupled emitters of the sixth and eighth transistor (24, 19) are connected to the zero potential (0) via a sixth current source (25), in that a ninth transistor (26), which is connected at the collector end to the first supply potential (10) and the base of which is provided as inverting input (30), is connected at the emitter end to the base of the seventh transistor (24) and to a terminal of a first serial pair of diodes (27) in the forward direction, the second terminal of which is connected, on the one hand, to the base of the first transistor (1) and, on the other hand, is connected to the zero potential (0) via a seventh current source (28, 29), and in that a tenth transistor (31), which is connected at the collector end to the first supply potential (10) and the base of which is provided as non-inverting input (3̅0̅), is connected at the emitter end to the base of the eighth transistor (19) and to a terminal of a second serial pair of diodes (32) in the forward direction, the second terminal of which is connected, on the one hand, to the base of the second transistor (2) and, on the other hand, is connected to the zero potential (0) via an eighth current source (33, 34).

6. Integrable circuit arrangement according to Claim 5, characterised in that the fifth and sixth transistor (22,17), the seventh and eighth transistor (24, 19), the ninth and tenth transistor (26, 31), the fourth and fifth current source (20, 21; 15, 16), the seventh and eighth current source (28, 29; 33, 34), and the first and second diode pair (27, 32) are in each case of identical construction and in that the third and fourth resistor (23, 18) have an identical resistance value.

7. Integrable circuit arrangement according to Claim 5 or 6, characterised in that the output stages (37, 38; 35, 36; 39, 40; 20, 21; 15, 16; 28, 29; 33, 34) of a seven-stage first current-balancing circuit, to the input end of which a ninth current source (43) is applied, are provided as first, second, third, fourth, fifth, seventh and eighth current source, and in that the current given by the sixth current source (25) can be adjusted from the outside.

8. Integrable circuit arrangement according to one of Claims 1 to 4, characterised in that the base of the third transistor (7) is connected to the collector of a seventh transistor (24) and the base of the fourth transistor (9) is connected to the collector of an eighth transistor (19),
in that the collector of the seventh transistor (24) is connected to a second supply potential (66) via a third resistor (23) and the collector of the eighth transistor (19) is connected to a second supply potential (66) via a fourth resistor (18),
in that in the ninth and tenth transistor (26, 31), a third supply potential (70) is applied to the collectors and the emitters are coupled to the zero point (0) via a first and, respectively, second diode (56, 55) in the forward direction and via a seventh and, respectively, eighth current source (28, 29; 33, 34),
in that the base of the ninth transistor (26) and the base of the tenth transistor (31) is in each case connected to the outputs of a differential amplifier (45, 46, 51, 52, 53, 54) with a ninth current source (45, 46), and in that the inputs of the differential amplifier (45, 46, 51, 52, 53, 54) are provided as inverting and non-inverting input (30, 3̅0̅).

9. Integrable circuit arrangement according to Claim 8, characterised in that the first supply potential (10) conducted in the forward direction via a further capacitor (71) and a further diode (57) is provided as the third supply potential and a fourth supply potential (67) conducted via a series resistor (62) is provided as the first supply potential (10).

10. Integrable circuit arrangement according to Claim 8 or 9, characterised in that the seventh and eighth transistor (24, 19), the ninth and tenth transistor (26, 31), the seventh and eighth current source (28, 29; 33, 34), the first and second diode (55, 56) and the third and fourth resistor (23, 18) are in each case identically constructed.

11. Integrable circuit arrangement according to Claim 8, 9 or 10, characterised in that the first, second and third current source are provided as output stages (37, 38; 35, 36; 39, 40) of a three-stage second current-balancing circuit having a reference-voltage source generating a first reference potential (63) as input stage, and, as seventh, eighth and ninth current source, the output stages (28, 29; 33, 34; 45, 46) of a three-stage third current-balancing circuit having a second reference-voltage source generating a second reference potential (64) as input stage are provided.

12. Integrable circuit arrangement according to Claim 7 or 11, characterised in that the first, second and third current source (37, 38; 35, 36; 39, 40) are designed in such a manner that the current densities in the transistors of the respective output stages are of equal magnitude.

13. Integrable circuit arrangement according to one of Claims 5 to 11, characterised in that a digital/analog converter with current output is provided as sixth current source (25).

14. Circuit arrangement according to one of Claims 1 to 13, characterised in that the signals present at the inverted and non-inverted output (1̅4̅, 14) are in each case conducted via emitter followers (47, 48, 60; 49, 50, 61) or amplifiers.

## Revendications

1. Montage intégrable pour retarder des signaux impulsionnels,
comportant un amplificateur différentiel pouvant être commuté par un signal d'entrée et comportant des premier et second transistors (1, 2), dont les émetteurs couplés sont raccordés à un potentiel nul (0) par l'intermédiaire d'une source de courant (3; 37, 38) et dont les collecteurs sont connectés entre eux par un condensateur (4) et dont les bases sont commandées en synchronisme avec le signal d'entrée et d'une manière inverse l'une de l'autre,
caractérisé par le fait que le collecteur du premier transistor (1) est raccordé, d'une part, par l'intermédiaire d'une seconde source de courant (5; 35, 36), au potentiel nul (0), et, d'autre part, à l'émetteur d'un troisième transistor (7) raccordé, côté collecteur, par l'intermédiaire d'une première résistance (6), à un premier potentiel d'alimentation (10), que le collecteur du second transistor (2) est raccordé, d'une part, par l'intermédiaire d'une troisième source de courant (11; 39, 40), au potentiel nul (0), et d'autre part à l'émetteur d'un quatrième transistor (9) raccordé, côté collecteur, par l'intermédiaire d'une seconde résistance (8), au premier potentiel d'alimentation (10), que le collecteur du troisième transistor (7) est prévu en tant qu'entrée inversée (1̅4̅) et le collecteur du quatrième transistor (9) est prévu en tant que sortie non inversée (14), que les premier et second transistors (1, 9) ou les second et troisième transistors (2, 7) sont commandés d'une manière réciproquement synchrone et que les potentiels, qui apparaissent lors de la commande des bases des troisième et quatrième transistors (7, 9), sont choisis supérieurs aux potentiels utilisés pour la commande des bases des premier et second transistors (1, 2), en sorte qu'est évitée une saturation des premier et second transistors (1, 2).

2. Montage intégrable suivant la revendication 1, caractérisé par le fait que le condensateur (4) est subdivisé en deux condensateurs partiels identiques (68, 69), comportant chacun trois plaques disposées les unes derrière les autres, que respectivement une plaque extérieure des condensateurs partiels est chargée par un potentiel auxiliaire (67) et que les deux autres plaques d'un premier condensateur partiel sont raccordées aux deux autres plaques de l'autre condensateur partiel selon un couplage croisé, en formant les bornes du condensateur (4).

3. Montage intégrable suivant la revendication 2, caractérisé par le fait que respectivement une diode de blocage (58, 59) est branchée dans le sens passant, en parallèle avec les première et seconde résistances (6, 8).

4. Montage intégrable suivant l'une des revendications 1 à 3, caractérisé par le fait que les premier et second transistors (1, 2), les troisième et quatrième transistors (7, 9), les seconde et troisième sources de courant (5; 35, 36; 11; 39, 40) ainsi que les première et seconde résistances (6, 8) possèdent des constitutions respectivement identiques.

5. Montage intégrable suivant l'une des revendications 1 à 4, caractérisé par le fait que la base du troisième transistor (7) est raccordée, d'une part, par l'intermédiaire d'une quatrième source de courant (20, 21), au potentiel nul (0), et, d'autre part, à l'émetteur d'un cinquième transistor (22), qui est raccordé par son collecteur au premier potentiel d'alimentation (10) et par sa base au collecteur d'un sixième transistor (24), qui est raccordé par l'intermédiaire d'une troisième résistance (23) au premier potentiel d'alimentation (10),
que la base du quatrième transistor (9) est raccordée, d'une part, par l'intermédiaire d'une cinquième source de courant (15, 16) au potentiel nul (0), et, d'autre part, à l'émetteur d'un sixième transistor (17), qui est raccordé par son collecteur au premier potentiel d'alimentation (10) et par sa base au collecteur d'un huitième transistor (19), raccordé par une quatrième résistance (18) au premier potentiel d'alimentation (10),
que les émetteurs couplés des septième et huitième transistors (24; 19) sont raccordés, par l'intermédiaire d'une sixième source de courant (25), au potentiel nul (0),
qu'un neuvième transistor (26), dont le collecteur est raccordé au premier potentiel d'alimentation (10), dont la base est prévue en tant qu'entrée inverseuse (30), est raccordé côté émetteur à la base du septième transistor (24) et à une borne d'un premier couple de diodes en série (27) dans le sens passant, dont la seconde borne est connectée, d'une part, à la base du premier transistor (1), et, d'autre part, par l'intermédiaire d'une septième source de courant (28, 29), au potentiel nul (0), et
qu'un dixième transistor (31), dont le collecteur est raccordé au premier potentiel d'alimentation (10) et dont la base est prévue en tant qu'entrée non inverseuse (3̅0̅), est raccordé, côté émetteur, à la base du huitième transistor (19) et à une borne d'un second couple de diodes en série (32) dans le sens passant, dont la seconde borne est raccordée, d'une part, à la base du second transistor (2), et, d'autre part, par l'intermédiaire d'une huitième source de courant (33, 34), au potentiel nul (0).

6. Montage intégrable suivant l'une des revendications 5, caractérisé par le fait que les cinquième et sixième transistors (22, 17), les septième et huitième transistors (24, 19), les neuvième et dixième transistors (26, 31), les quatrième et cinquième sources de courant (20, 21; 15, 16), les septième et huitième sources de courant (28, 29; 33, 34), ainsi que les premier et second couples de diodes (27, 32), sont respectivement identiques et que les troisième et quatrième résistances (23, 18)possèdent la même valeur résistive.

7. Montage intégrable suivant l'une des revendications 5 ou 6, caractérisé par le fait qu'il est prévu comme première, seconde, troisième, quatrième, cinquième, septième et huitième sources de courant, les étages de sortie (37, 38; 35, 36; 39, 40; 20, 21; 15, 16; 28, 29; 33, 34) d'un premier miroir de courant à sept étages, qui est chargé à son entrée par une neuvième source de courant (43), et que le courant délivré par la sixième source de courant (25) est réglable de l'extérieur.

8. Montage intégrable suivant l'une des revendications 1 à 4, caractérisé par le fait
que la base du troisième transistor (7) est raccordée au collecteur d'un septième transistor (24) et que la base du quatrième transistor (9) est raccordée au collecteur d'un huitième transistor (19),
que le collecteur du septième transistor (24) est raccordé, par l'intermédiaire d'une troisième résistance (23), et le collecteur du huitième transistor (19), par l'intermédiaire d'une quatrième résistance (18), à un second potentiel d'alimentation (66),
que pour les neuvième et dixième transistors (26, 31), les collecteurs sont chargés par un troisième potentiel d'alimentation (70) et les émetteurs sont couplés au point nul (0) par l'intermédiaire de première et seconde diodes (56, 55) dans le sens passant et par l'intermédiaire de septième et huitième sources de courant (28, 29; 33, 34),
que la base du neuvième transistor (26) et la base du dixième transistor (31) sont raccordées respectivement aux sorties d'un amplificateur différentiel (45, 46, 51, 52, 53, 54) possédant une neuvième source de courant (45, 46) et que les entrées de l'amplificateur différentiel (45, 46, 51, 52, 53, 54) sont prévues en tant qu'entrées inverseuse et non inverseuse (30, 3̅0̅).

9. Montage intégrable suivant la revendication 8, caractérisé par le fait qu'il est prévu, comme troisième potentiel d'alimentation, le premier potentiel d'alimentation (10) appliqué, par l'intermédiaire d'un autre condensateur (71) et d'une autre diode (57) dans le sens passant, et comme premier potentiel d'alimentation (10), un quatrième potentiel d'alimentation (67) appliqué par l'intermédiaire d'une résistance additionnelle (62).

10. Montage intégrable suivant la revendication 8 ou 9, caractérisé par le fait que les septième et huitième transistors (24, 19), les neuvième et dixième transistors (26, 31), les septième et huitième sources de courant (28, 29; 33, 34), les première et seconde diodes (55, 56) ainsi que les troisième et quatrième résistances (23, 18), sont respectivement identiques.

11. Montage intégrable suivant la revendication 8, 9 ou 10, caractérisé par le fait que les première, seconde et troisième sources de courant sont prévues en tant qu'étages de sortie (37, 38; 35, 36; 39, 40) d'un second miroir de courant à trois étages, comportant une source de tension de référence produisant un premier potentiel de référence (63), en tant qu'étage d'entrée, et que les septième, huitième et neuvième sources de courant constituent les étages de sortie (28, 29; 33, 34; 45, 46) d'un troisième miroir de courant à trois étages, comportant une seconde source de tension de référence produisant un second potentiel de référence (64), en tant qu'étage de sortie.

12. Montage intégrable suivant la revendication 7 ou 11, caractérisé par le fait que les première, seconde et troisième sources de courant (37, 38; 35, 36; 39, 40) sont agencées de telle sorte que les densités de courant dans les transistors des étages de sortie respectifs sont identiques.

13. Montage intégrable suivant l'une des revendications 5 à 11, caractérisé par le fait qu'il est prévu, comme sixième source de courant (25), un convertisseur numérique/analogique possédant une sortie de courant.

14. Montage intégrable suivant l'une des revendications 1 à 13, caractérisé par le fait que les signaux présents sur les sorties inversée et non inversée (1̅4̅, 14) sont transmis respectivement par l'intermédiaire d'émetteurs-suiveurs (47, 48, 60; 49, 50, 61) ou d'amplificateurs.
